# EUROPÄISCHE PATENTANMELDUNG

(11) **EP 0 834 995 A1**
(43) Veröffentlichungstag der Anmeldung: **08.04.1998**
(21) Anmeldenummer: 96440078.2
(22) Anmeldetag: 07.10.1996
(51) Int. Cl.: H03M 7/00

(54) **ADPCM-Transkodierer**

(71) Anmelder: ALCATEL ALSTHOM COMPAGNIE GENERALE D'ELECTRICITE, 75008 Paris (FR)
(72) Erfinder: Pinier, François, 67100 Strasbourg (FR); Hoff, Jean, 67700 Saint Jean Saverne (FR)
(74) Vertreter: Knecht, Ulrich Karl, Dipl.-Ing.

(57) **Zusammenfassung**

Schaffung eines ADPCM Transcoders, der nach vorgegebenen Empfehlungen arbeitet, und der mindestens 12 Kanäle zur Verfügung stellt und dabei kostengünstig zu realisieren ist.

ADPCM Transcoder, bei dem der ADPCM Algorithmus auf eine Zeitsequenz abgebildet wird und mittels integrierter Schaltelemente nachgebildet wird.

Der ADPCM Transcoder wird aus integrierten, logischen Schaltelementen gebildet (ohne Verwendung eines Prozessors), wobei die arithmetischen Funktionen und die logischen Operationen gemäß der ITU-T Recommendations G727/G726 ausgeführt werden. Die Anwendungszeit des ADPCM Algorithmus pro Kanal wird dabei sehr kurz, weshalb pro Zeitrahmen 16 Kanäle bearbeitet werden können.

## Beschreibung

Die Erfindung betrifft einen ADPCM Transcoder zur Codeumsetzung von Signalen unterschiedlicher Übertragungsraten.

Aus der ITU-T-Empfehlung G.727 ist eine Spezifikation für die ADPCM (Adaptive Differential Pulse Code Modulation)-Algorithmen bekannt. Die Empfehlung definiert die Grundlagen zur Transcodierung, also der Codeumwandlungen, eines PCM (Pulse Code Modulated)-Signals von 64 kbit/s in ein ADCPM-Signal. Gemäß der ITU-T-Empfehlung kann dies ein 40, 32, 24, oder 16 Kbit/s ADPCM-Signal sein (Aus: CCITT-Recommendation G.727, General Aspects of Digital Transmission Systems; Terminal Equipments, 5-, 4-, 3- und 2-Bits Sample Embedded Adaptive Differential Pulse Code Modulation (ADPCM), Genf 1990).

Eingesetzt zur ADPCM-Transcodierung werden Schaltkreise, die einen Prozessor oder mehrere Prozessoren aufweisen. Über einen solchen Transcoder müssen eine Vielzahl von Kanälen transcodiert werden. Beispielsweise bei DECT (Digital Enhanced Cordless Telephony) müssen 12 Kanäle zur Verfügung stehen. Bekannte Schaltkreise, die eine ADPCM-Transcodierung durchführen, stellen pro Schaltkreis maximal 4 Kanäle zur Verfügung. Um nun beispielsweise 12 Kanäle für DECT bereitzustellen, müssen somit mindestens 3 Schaltkreise zur Verfügung gestellt werden. Dies bedeutet aber, daß mindestens 3 verschiedene Prozessoren, vielmehr DSP's bereitgestellt werden müssen, um 12 Kanäle zur Verfügung zu stellen. Dies führt aber zu einem großen Stromverbrauch und zu nicht unbeträchtlichen Kosten.

Aufgabe der vorliegenden Erfindung ist es nun einen solchen ADPCM-Transcoder anzugeben, der eine Vielzahl von Kanäle bereitstellt, der nach vorgegebenen Empfehlungen arbeitet und der gleichzeitig kostengünstig realisierbar ist.

Dies wird erfindungsgemäß gelöst durch die Lehre des Patentanspruches 1.

Vorteilhaft erweist sich hierbei, daß bei Verwendung logischer Schaltelemente anstelle der Verwendung eines Prozessors die Ausführungszeit eines ADPCM-Algorithmus nicht mehr von der Geschwindigkeit des Prozessors abhängig ist, sondern von der reinen Ausführungszeit pro Kanal. Weiterhin vorteilhaft ergibt sich daraus auch, daß mehrere Kanäle gleichzeitig bearbeitet werden können. Hieraus ergibt sich, daß 16 Kanäle zur Verfügung gestellt werden können.

Weiterhin vorteilhaft ist, daß ein sowieso vorhandenes Taktsignal DCL verwendet werden kann und somit ein externer Quarz entfällt. Außerdem vorteilhaft ist, daß ein solcher ADPCM-Transcoder einen geringen Stromverbrauch aufweist.

Weitere vorteilhafte Ausgestaltungen sind den Unteransprüchen 2 bis 5 zu entnehmen. Vorteilhafte Verwendungen ergeben sich aus den Patentansprüchen 5 bis 7.

Gemäß Patentanspruch 5 erweist sich als vorteilhaft, daß der ADCPM-Transcoder zur Codeumsetzung für die Standards DECT, für den PWT-Standard, für PHS.

Im folgenden wird die Erfindung anhand von Ausführungsbeispielen und der vorliegenden Figuren näher erläutert. Folgende Figuren zeigen:
- Fig. 1:: Schematische Darstellung des erfindungsgemäßen ADPCM-Transcoders,
- Fig. 2:: Blockdiagramm einer Ausgestaltung des ADPCM-Transcoders,
- Fig. 3:: Zeitdiagramm der Transcodierung.

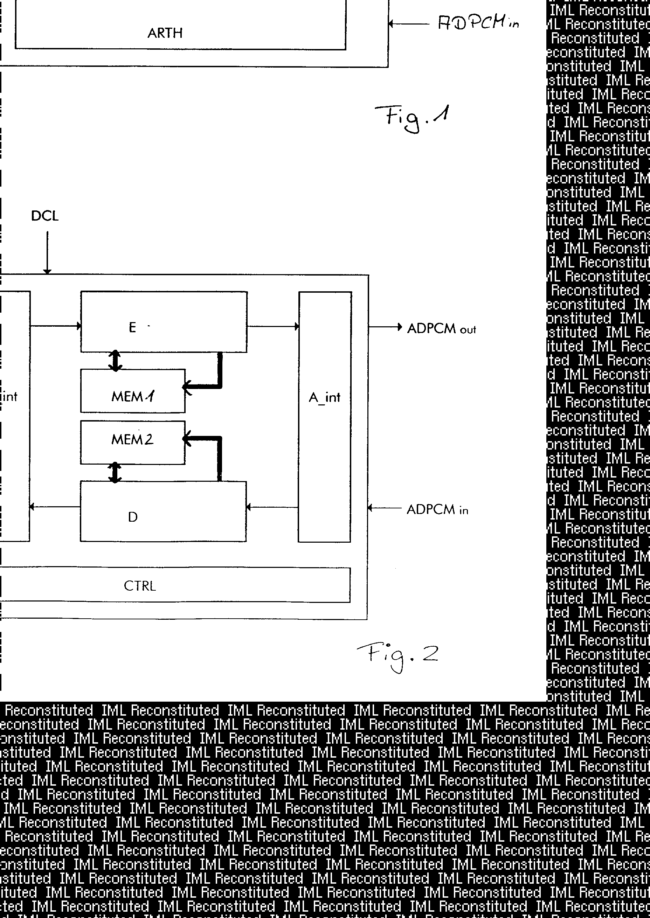

Im folgenden wird anhand von Figur 1 die Grundlage des erfindungsgemäßen ADPCM Transcoders erläutert. Auf einen ADPCM Transcoder ADPCM wird ein Eingangssignal PCMin z.B. als PCM codiertes Signal gegeben. Ebenfalls wird von dem ADPCM Transcoder ADPCM ein PCM-Signal über einen PCM-Ausgang PCMout ausgegeben. Ein Ausgang ADPCMout gibt ein ADPCM codiertes Signal aus. Über einen Eingang des ADPCM Transcoders ADPCM wird ein ADPCM-codiertes Signal ADPCMin eingegeben. Innerhalb des ADPCM-Transcoders ADPCM befindet sich eine Einheit ARTH, die aus Hardware, also aus logischen Schaltelementen besteht, zur Durchführung der arithmetischen Funktionen, wie z. B. einer Subtraktion, einer Addition, einer Multiplikation, einer Division, usw., und zur Durchführung logischer Operationen, wie z. B. Vergleichsoperationen, oder Testoperationen, usw.. Dieser Einheit ARTH zugeordnet ist eine Steuereinheit CTRL und ein Speicher MEM. Die Steuereinheit CTRL steuert die ADPCM-Transcodierung. In dem hier angegebenen Fall, daß die Transcodierung nur durch Hardware durchgeführt wird, ist ein Speicher MEM vorhanden zur Zwischenspeicherung und demgemäß zur Vermeidung eines Datenverlustes.

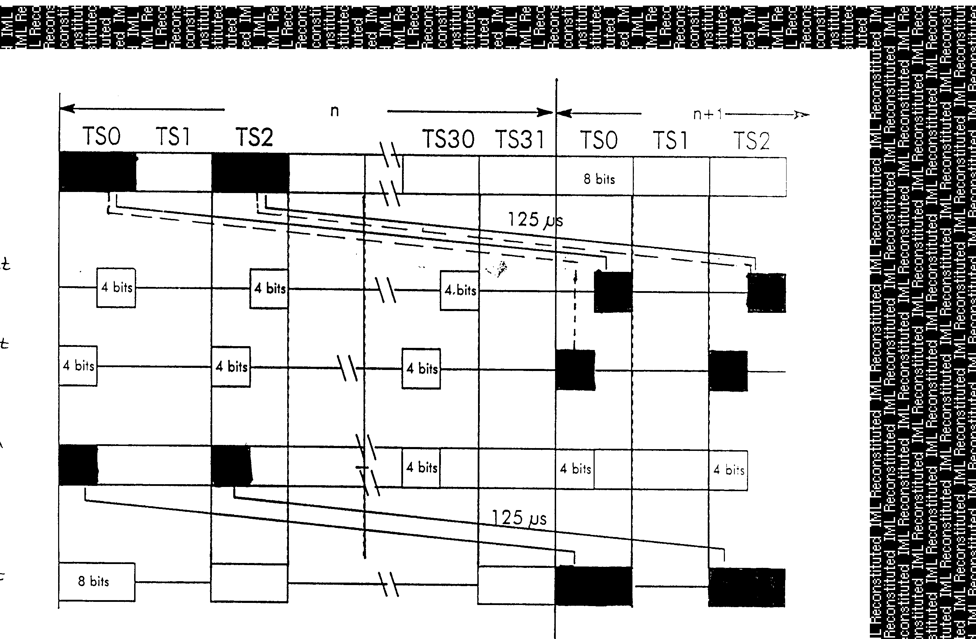

Im folgenden wird anhand von Figur 2 ein Blockschaltbild des erfindungsgemäßen ADPCM-Transcoders erläutert. Ein ADPCM-Transcoder weist einen PCM-Eingang PCMin und einen PCM-Ausgang PCMout auf. Diesen Ausgängen und Eingängen zugeordnet ist ein Schnittstellenschaltkreis P_int als Eingangs- und Ausgangsschnittstellenschaltkreis. Weiter weist der ADPCM Transcoder einen ADPCM-Eingang ADPCMin und einen ADPCM-Ausgang ADPCMout auf. Dem ADPCM-Eingang und dem ADPCM-Ausgang ist ein Schnittstellenschaltkreis A_int zugeordnet. Ein PCM codiertes Signal wird über den PCM-Eingang PCMin auf den ADPCM Transcoder gegeben. Das PCM-Signal soll ADPCM transcodiert werden und über den ADPCM-Ausgang ADPCMout ausgegeben werden. Die Aufnahme des PCM codierten Signals erfolgt über den zugeordneten Schnittstellenschaltkreis P_int und die Ausgabe über den zugeordneten Schnittstellenschaltkreis A_int. Innerhalb des ADPCM-Transcoders muß eine Codierung von PCM in ADPCM erfolgen. Dazu ist in dem ADPCM-Transcoder eine aus logischen Schaltelementen aufgebaute Codiereinrichtung E und ein erster zugeordneter Speicher MEM1 angeordnet. Ein PCM codiertes Signal wird auf die Codiereinrichtung E gegeben und wird dann, über den dem Ausgang ADPCMout zugeordneten Schnittstellenschaltkreis A_int ausgegeben. Der Einsatz des zugeordneten ersten Speichers MEM1 wird später noch näher erläutert. Der ADPCM Transcoder, also der Codeumsetzer, arbeitet auch in der umgekehrten Richtung. Das bedeutet, ein ADPCM-codiertes Signal wird über den Eingang ADPCMin auf den ADPCM-Transcoder gegeben. Dieses ADPCM codierte Signal soll PCM codiert ausgegeben werden, was über den PCM-Ausgang PCMout erfolgt. Über den dem ADPCM-Eingang ADPCMin zugeordneten Schnittstellenschaltkreis A_int wird das ADPCM codierte Signal aufgenommen. Der dem PCM-Ausgang PCMout zugeordnete Schnittstellenschaltkreis P_int gibt das PCM codierte Signal aus. Innerhalb des ADPCM-Transcoders muß aus dem ADPCM codierten Signal ein PCM codiertes Signal erzeugt werden. Dazu ist eine Decodiereinrichtung D innerhalb des ADPCM-Transcoders vorgesehen. Die Decodiereinrichtung D ist aus logischen Schaltelementen aufgebaut. Zusätzlich ist der Decodiereinrichtung D ein zweiter Speicher MEM2 zugeordnet zur Zwischenspeicherung der Daten und zur Vermeidung eines Datenverlustes. Der Einsatz des Speichers wird später näher erläutert. Innerhalb des ADPCM-Transcoders ist eine Steuereinrichtung CTRL angeordnet, die die Steuerung der ADPCM-Transcodierung vornimmt. Einen Einsatz findet ein solcher ADPCM Transcoder, beispielsweise bei einem 64 kbit/s codierten PCM-Signal in der Umsetzung in ein 32 kbit/s ADPCM codierten Signals. Zur Ansteuerung der Schaltkreise P_int, A_int und der Codier-/Decodiereinrichtungen E, D und der Speicher MEM1, MEM2 wird ein Taktsignal DCL verwendet. Dieses Taktsignal DCL hat üblicherweise eine Frequenz von 4,096 MHz und ist üblicherweise bereits als anliegendes Signal vorhanden, weshalb kein externer Quarz zur Takterzeugung verwendet werden muß. Die Codiereinrichtung E und die Decodiereinrichtung D sind, wie bereits erwähnt, aus logischen Schaltelementen aufgebaut. Diese logischen Schaltelemente können beispielsweise logische Gatter sein. Diese dienen dazu den ADPCM-Algorithmus, der auf eine Zeitsequenz abgebildet wurde und der zur ADPCM Transcodierung dient, mittels Hardware auszuführen. Aufgrund der Verwendung der logischen Schaltelemente anstelle eines Prozessors, können gleichzeitig mehrere Kanäle bearbeitet werden und die Bearbeitung eines Kanales ist nicht mehr abhängig von der Geschwindigkeit des verwendeten Prozessors. Daraus resultiert auch, daß mittels der Hardware eine bestimmete festgelegte Anzahl von Kanälen bereitgestellt wird, wie dies später noch erläutert wird.

Hierbei arbeitet der ADPCM-Transcoder beispielsweise nach den in den ITU-T G727 angegenen Empfehlungen, oder nach den in den ITU-T G726 angegebenen Empfehlungen.

Im folgenden wird dies anhand von Figur 3 näher erläutert. In dem Beispiel dargestellt ist die Transcodierung eines 64 kbit/s PCM codierten Signals in ein 32 kBit/s ADPCM codiertes Signal. Dargestellt in Figur 3 ist ein erster Rahmen n und ein zweiter Rahmen n+ 1 aus einer Vielzahl von Rahmen. Pro Rahmen sind 32 Zeitschlitze TS0, TS1, ..., TS31 vorgesehen. Jeder Zeitschlitz TS0, TS1, ..., TS31 ist 8 Bit lang. Besonders hervorgehoben werden hier beispielhaft die 8 Bit des ersten Zeitschlitzes TS0 und die 8 Bit des dritten Zeitschlitzes TS2 des Rahmens n (schwarze Felder). Ein auf den ADPCM Transcoder gegebenes PCM-Signal PCMin wird zeitverzögert an dem Ausgang ADPCMout ausgegeben. Die Zeitverzögerung beträgt 125 µs, resultierend aus der in der Telefonie üblichen Abtastfrequenz von 8 kHz. Durch die Transcodierung wird eine Codeumsetzung eines 8 Bit langen Signales in ein 4 Bit langes Signal vorgenommen. Das PCM codierte Signal an dem PCM-Eingang PCMin, das bei dem ersten Zeitschlitz TS0 vorliegt, wird auf den zweiten Rahmen n+ 1 in den Zeitschlitz 0 abgebildet. An dem ADPCM-Ausgang ADPCMout, welcher hier durch 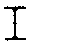 ADPCMout und 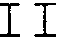 ADPCMout angegeben ist, kann das in 4 Bit vorliegende Signal im ersten Bereich (durchgezogene Linie) des Zeitschlitzes oder in dem zweiten Bereich (gebrochene Linie) des Zeitschlitzes des n+ 1ten Rahmens ausgegeben werden. In umgekehrter Richtung wird ein ADPCM codiertes Signal an den ADPCM-Eingang ADPCMin gegeben. Hier beispielhaft dargestellt sind wieder die ersten 4 Bits des ersten Zeitschlitzes TS0 oder die ersten 4 Bit des dritten Zeitschlitzes TS2. Diese werden ebenfalls zeitverzögert mit 125 µs auf 8 Bit an den PCM-Ausgang PCMout übertragen. Dort werden diese demgemäß um 125 µs zeitverzögert in 8 Bit Format ausgegeben. Hieraus ergibt sich auch die Verwendung der den Codier- und Decodiereinrichtungen zugeordneten Speicher MEM1 und MEM2. Wegen der Zeitverzögerung, die hier beispielsweise 125 µs beträgt, müssen die Signale zwischengespeichert werden um einen Datenverlust zu vermeiden. Dazu dient jeweils der Speicher MEM1 oder der Speicher MEM2 entsprechend ob codiert oder decodiert wird.

Im folgenden werden einige Verwendungen des erfindungsgemäßen ADPCM-Transcoders erläutert. Für die schnurlose Telekommunikation wird beispielsweise eine 32 kbit/s ADPCM-Transcoder-Funktion benötigt. Z.B. für DECT (Digital Enhanced Cordless Telephony) oder der CT2-Standard oder PHS (japanischer Standard für schnurlose Telekommunikation) oder PWT (nordamerikanischer Standard). Hierbei dient der ADPCM-Transcoder dazu, ankommende beispielsweise PCM mit 64 kbit/s codierte Signale in ADPCM-Signale mit 32 kbit/s umzusetzen. Dies erfolgt auch in umgekehrter Richtung. Dazu wird der ADPCM-Transcoder zwischengeschaltet. Bei der Anwendung bei DECT müssen beispielsweise 12 Kanäle zur Verfügung gestellt werden. Mit der erfindungsgemäßen Anordnung ist es wegen der kurzen Bearbeitungszeiten bei der Anwendung des Algorithmus aber möglich 16 Kanäle bereitzustellen. Dies ergibt sich, wie bereits erläutert aus den kurzen Berechnungszeiten und bezogen auf die Figur 3 damit aus den 32 Zeitschlitzen, von denen jeweils einer für die Übertragung in eine Richtung und der andere für die Rückübertragung in die rückwärtige Richtung dient. Daraus resultiert, daß 16 Kanäle zur Verfügung stehen. Bei DECT werden davon 12 benötigt, sodaß noch 4 freie Kanäle für weitere Anwendungen zur Verfügung stehen.

Eine weitere Anwendung ist die Sprachkompression in eine Nebenstellenanlage. Hierbei kann beispielsweise ein ADPCM Transcoder, vielmehr ein 32 kbit/s Transcoder aus 30 PCM Sprachkanölen 60 Sprachkanäle bereitstellen.

Eine weitere Anwendung ist die Sprachkompression für Sprachserver. Auch eine Anwendung ist es, eine Vielzahl von parallelen ADPCM Transcodern einzusetzen. Hierbei erhöht sich die Anzahl der zur Verfügung gestellten Kanäle entsprechend des angebotenen Pools von ADPCM Transcodern.

## Patentansprüche

1. ADPCM Transcoder
mit einem PCM-Eingang (PCMin) und einem PCM-Ausgang (PCMout),
mit einem ADPCM-Eingang (ADPCMin) und einem ADPCM-Ausgang (ADPCMout),
mit einer aus logischen Schaltelementen aufgebauten Hardwareeinheit (ARTH) zur Ausführung arithmetischer Funktionen und logischer Operationen,
mit einem Speicher (MEM) zur Speicherung von Daten, und
mit einer Steuereinrichtung (CTRL) zur Steuerung der Transcodierung.

2. ADPCM Transcoder nach Anspruch 1,
bei dem der PCM-Eingang (PCMin) und der PCM-Ausgang (PCMout) mit einem ersten Schnittstellenschaltkreis (P_int) verbunden sind,
bei dem der ADPCM-Eingang (ADPCMin) und der ADPCM-Ausgang (ADPCMout) mit einem zweiten Schnittstellenschaltkreis (A_int) verbunden sind,
bei dem die Hardwareeinheit (ARTH) in eine Codiereinrichtung (E) und eine Decodiereinrichtung (D) integriert ist,
und bei der der Speicher (MEM) in einen ersten, der Codiereinrichtung zugeordneten Speicher (MEM1) und in einen zweiten, der Decodiereinrichtung zugeordneten Speicher (MEM2) aufgeteilt ist.

3. ADPCM Transcoder nach Anspruch 2,
mit einem Taktsignal (DCL) zur Ansteuerung der Schaltkreise (PCM_int, ADPCM_int) und der Einrichtungen (E, D) und der Speicher (MEM1, MEM2).

4. ADPCM Transcoder nach einem der Ansprüche 1 bis 3,
bei dem die logischen Schaltelemente logische Gattern sind.

5. ADPCM Transcoder nach einem der Ansprüche 1 bis 4,
wobei der ADPCM Transcoder gemäß der in den G727 / G726 - Empfehlungen empfohlenen Algorithmen arbeitet.

6. Verwendung des ADPCM Transcoders nach Anspruch 1 zur Codeumsetzung für die Standards DECT, PWT und PHS.

7. Verwendung des ADPCM-Transcoders nach Anspruch 1 zur Sprachkomprimierung für Sprach-Server.

8. Verwendung einer Vielzahl paralleler ADPCM-Transcoder nach Anspruch 1 zur Bereitstellung eines Pools von Kanälen.
